Europäisches Patentamt

European Patent Office

Office européen des brevets

(11) Veröffentlichungsnummer : **0 037 360**
**B1**

# (12) EUROPÄISCHE PATENTSCHRIFT

(45) Veröffentlichungstag der Patentschrift :
26.09.84

(21) Anmeldenummer : **81710003.5**

(22) Anmeldetag : **19.02.81**

(51) Int. Cl.³ : **G 06 K 19/04**, B 23 Q 41/02,
G 11 C 23/00

(54) **Kodiersystem.**

(30) Priorität : **29.03.80 DE 3012358**

(43) Veröffentlichungstag der Anmeldung :
**07.10.81 Patentblatt 81/40**

(45) Bekanntmachung des Hinweises auf die Patenterteilung : **26.09.84 Patentblatt 84/39**

(84) Benannte Vertragsstaaten :
**CH DE FR GB IT LI**

(56) Entgegenhaltungen :
**DE-A- 1 449 131**
**DE-A- 1 814 452**
**FR-A- 2 284 930**
**US-A- 3 173 533**
**US-A- 3 802 559**

(73) Patentinhaber : **ROBERT BOSCH GMBH**
**Postfach 50**
**D-7000 Stuttgart 1 (DE)**

(72) Erfinder : **Leisner, Ernst, Dipl.-Ing.**
**Wettertalstrasse 4**
**D-7257 Ditzingen (DE)**
Erfinder : **Jung, Rainer**
**Metzstrasse 11**
**D-7000 Stuttgart 1 (DE)**

## Beschreibung

### Stand der Technik

Die Erfindung geht aus von einem Kodiersystem nach der Gattung des Hauptanspruchs. Bei einem bekannten Kodiersystem dieser Gattung sind Kodierelemente als verschiebbar gelagerte Kodierbolzen ausgebildet, die durch einen Schreibkopf unabhängig voneinander in ihre erste oder zweite Position gesetzt werden können. Zum Verschieben eines Kodierbolzens in die gewünschte Position werden zwei Verschiebestempel im Schreibkopf benötigt, welche jeweils in entgegengesetzten Richtungen auf den Kodierbolzen einwirken. Diese Ausführung benötigt einen verhältnismäßig aufwendigen Schreibkopf und eine aufwendige Auswerteschaltung, wenn diese möglichst freizügig für verschiedene Informationen (Kodiermuster) programmierbar und auch so ausgebildet sein soll, daß sie die gespeicherten Informationen durch Abgabe entsprechender Steuerbefehle auszuwerten vermag. Eine gleich aufwendige Auswerteschaltung hat ein Kodiersystem (US-A-3 173 533), bei welchem die Kodierelemente durch magnetisierbare Plättchen gebildet sind, von denen ebenfalls ein jedes für sich unabhängig von den anderen Plättchen in einen einer bestimmten Information entsprechenden Magnetzustand versetzt werden kann.

### Vorteile der Erfindung

Die erfindungsgemäße Anordnung mit den kennzeichnenden Merkmalen des Hauptanspruchs hat demgegenüber den Vorteil, daß jede zu speichernde Information durch ein einheitliches Erkennungssignal darstellbar und dadurch die Auswerteschaltung einfach durch entsprechendes Einstellen der Umschalteinrichtungen programmierbar ist. Die Auswerteschaltung kann insbesondere in Modul-Bauweise verwirklicht werden, wobei die einzelnen Module nach dem Baukastenprinzip elektrisch und mechanisch miteinander verbindbar sein können.

Durch die in den Unteransprüchen aufgeführten Maßnahmen sind vorteilhafte Weiterbildungen der im Hauptanspruch angegebenen Anordnung möglich.

Mit den Merkmalen der Ansprüche 2 bis 4 läßt sich die Auswerteschaltung auf besonders einfache Weise verwirklichen.

Durch die Merkmale des Anspruchs 5 ergibt sich ein einfacher Aufbau des mechanischen Speichers des Kodiersystems und der Vorteil, daß sämtliche Kodierbolzen von ein- und derselben Seite her einstellbar sind, wodurch sich auch der Schreibkopf entsprechend vereinfacht.

### Zeichnung

Ein Ausführungsbeispiel der Erfindung is in der Zeichnung dargestellt und in der nachfolgenden Beschreibung näher erläutert. Es zeigen :

Figur 1 eine Seitenansicht,

Figur 2 eine Rücksansicht des erfindungsgemäßen Kodierblocks mit zugehörigem Lesekopf,

Figur 3 einen Schnitt durch einen Kodierblock,

Figur 4 eine Schaltungsanordnung im Lesekopf.

### Beschreibung der Erfindung

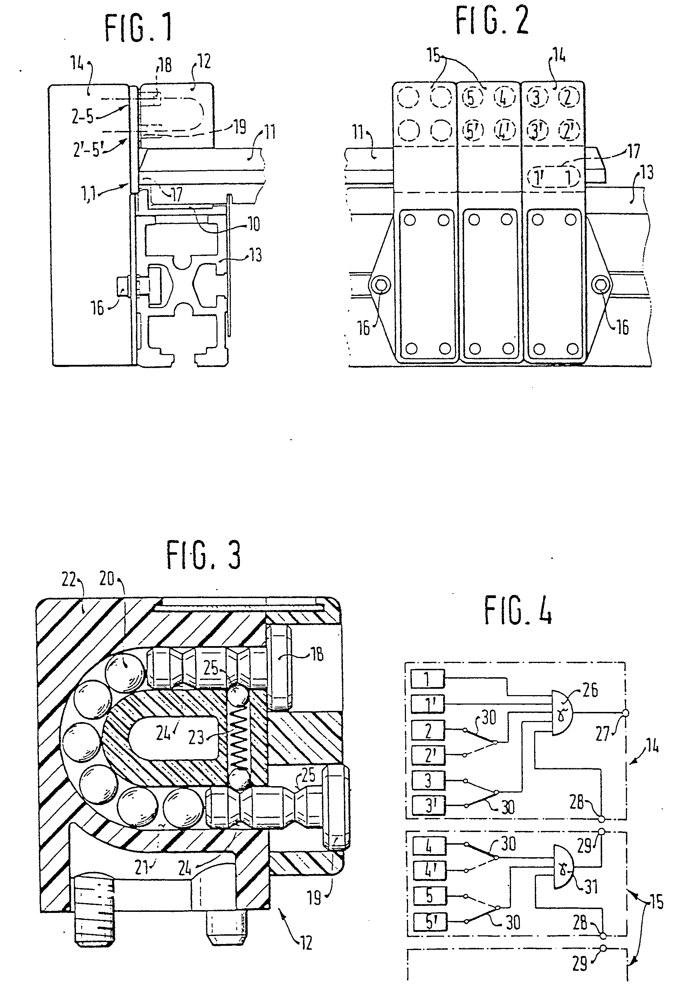

In Fig. 1 läuft auf einem Transportband 10 eines Doppelgurt-Bandes ein Werkstückträger 11 mit darauf befestigtem Kodierblock 12. Am Bandgestell 13 ist der Lesekopf 14, 15 mittels Schrauben 16 befestigt.

In Fig. 2 ist eine Rücksansicht der Leseköpfe 14, 15 dargestellt. Der erste Lesekopf 14 enthält insgesamt sechs induktive Näherungsschalter 1, 1' bis 3, 3'. Die Näherungsschalter 1, 1' dienen der Erfassung des Werkstückträgers 11. Hierfür weist der Kunststoff-Werkstückträger 11 an einer Seitenfläche eine ovale sensitive Metallfläche 17 auf. Die Metallfläche 17 ist gerade so groß, daß die Außenkonturen der induktiven Näherungsschlater 1, 1' abgedeckt werden. Durch die doppelte Anordnung sowie durch die Und-Verknüpfung der Näherungsschalter geben diese nur dann ein Signal ab, wenn die Metallfläche 17 am Werkstückträger genau gegenüber den Näherungsschaltern 1, 1' positioniert ist. Hierfür kann jedoch in einer einfacheren Ausführung auch nur ein Sensor verwendet werden.

Die Metallfläche 17 am Werkstückträger 11 befindet sich nicht im Bereich der Kodierblöcke 14, 15, sondern an einer Seitenfläche des Werkstückträgers 11. Die Näherungsschalter 1, 1' zur Erkennung des Werkstückträgers können demnach nicht von den Kodierbolzen 18, 19 des Kodierblocks 12 oder weiteren entsprechenden Kodierblöcken beeinflußt werden.

Der erste Lesekopf 14 enthält weiterhin Näherungsschalter 2, 2' ; 3, 3' zur Erkennung der Lage von zugehörigen Kodierbolzen 18, 19 sowie zwei weiteren entsprechenden parallel angeordneten Kodierbolzen im Kodierblock 12.

Die weiteren Leseköpfe 15 enthalten ebenfalls jeweils zwei einander zugeordnete Sensorenpaare 4, 4' ; 5, 5' usw. zur Erfassung der Lage weiterer dem Kodierblock 12 entsprechenden Kodierblöcken.

In Fig. 3 ist ein Schnitt durch einen Kodierblock 12 dargestellt. Die Kodierbolzen 18, 19 sind über einen Kugelmechanismus, bestehend aus hintereinander aufgereihten Stahlkugeln 20, die in einer kreisförmigen Bohrung 21 im Kodierblockgehäuse 22 laufen, miteinander verbunden. Eine Sicherung der Kodierbolzen in der jeweiligen Endlage geschieht durch einen Kugel-Federmechanismus, der in entsprechende Nuten 24, 25 der Kodierbolzenschafte eingreift. Jeder Kodierblock 12 enthält zwei derartige Kodierbolzen 18, 19, deren räumliche Lage genau der Lage der Näherungsschaltung zur Erfassung der Kodierbolzen im Lesekopf 14, 15 angepaßt ist.

Wie in Fig. 4 schematisch dargestellt, enthält der Lesekopf 14 drei Sensorenpaare 1, 1′ bis 3, 3′. Die Näherungsschalter 1, 1′ sind über das Und-Gatter 26 miteinander verknüpft. Ein Signal wird nur dann an die Klemme 27 weitergegeben, falls die Metallfläche 17 des Werkstückträgers 11 an beiden Näherungsschaltern 1, 1′ anliegt und durch die übrigen Sensoren Signale auch an den übrigen Eingängen des Und-Gatters 26 erzeugt werden...

Die weiteren im Lesekopf 14 enthaltenen Näherungsschalter 2, 2′ und 3, 3′ 3′ dienen der Erfassung des ersten Kodierblocks 12. Weitere Leseköpfe 15, die über die Klemmen 28, 29 mit dem vorhergehenden Lesekopf verbunden werden, dienen ebenfalls der Erfassung der Lage der Kodierbolzen 18, 19 von weiteren hintereinander geschalteten Kodierblöcken 12. Hierdurch kann die Anzahl der Kodiermöglichkeiten beliebig erhöht werden. Die zur Erfassung der Lage der Kodierbolzen 18, 19 vorgesehenen Näherungsschalter 2, 2′, 3, 3′ usw. weisen jeweils einen Umschalter 30 auf. Dieser vorzugsweise mechanische Umschalter 30 in den einzelnen Leseköpfen dient zur freien Programmierung von gewünschten Kodiermöglichkeiten.

Das Vorprogrammieren der Leseköpfe 14, 15 mittels Schalter 30 geschieht zum Beispiel wie folgt : Nach einem vollzogenen Bearbeitungsgang am Werkstück in einer Bearbeitungsstation wird ein Kodierbolzen im Kodierblock 12 umgesetzt. In der nächstfolgenden Bearbeitungsstation wird der zu dem umgesetzten Kodierbolzen zugehörige Näherungsschalter mittels dem Schalter 30 eingeschaltet, so daß der vollzogene Bearbeitungsgang an dieser folgenden Station erfaßt werden kann. Die eingeschalteten Näherungsschalter müssen demnach an jeder Station durch die richtige Lage der entsprechenden Kodierbolzen ein Signal abgeben, welches durch die Und-Verknüpfung z. B. über die Und-Gatter 26, 31 zu einem einzigen Ausgangssignal an der Klemme 27 führt. Eine beliebige Anzahl von Kodierblöcken und zugehörigen Leseköpfen führt deshalb immer bei dieser sogenannten « Zielkodierung » zu einem einzigen Ausgangssignal an der Klemme 27. Dieses Ausgangssignal bestätigt den ordnungsgemäßen Verlauf des Bearbeitungs- bzw. Montagevorgangs und/oder steuert den weiteren Bearbeitungsgang am Werkstück.

An der Klemme 28 des letzten Lesekopfs wird ein Potential angelegt, das dem positiven Einschaltpegel der verwendeten Gatterart entspricht. Die beliebige Anzahl von aneinander schaltbaren Leseköpfen benötigen deshalb nur eine Spannungsversorgung sowie einen Anschluß 27 zur Registrierung ob die eingestellte Kombination und somit der ordnungsgemäße Verlauf des Montagevorgangs stimmt.

Die Spannungsversorgung (z. B. 24 V=) aller Leseköpfe erfolgt über den ersten Lesekopf 14 und die Klemmen 28, 29.

Durch die Umschalter (Wahlschalter) 30 in den Leseköpfen 14, 15 werden die Näherungsschalter 2, 2′ ; 3, 3′ usw. derart vorgewählt, daß die der an der Abfragestelle zu erwartende Kombination der Kodierung der Kodierbolzen, 18, 19 im Kodierblock 12 entspricht. Die so ausgewählten Näherungsschalter werden über die integrierten Logikbausteine 26, 31 so verknüpft, daß an der Klemme 27 des Lesekopfs 14 ein Signal dann entsteht, wenn die Kombination an allen Leseköpfen stimmt (Übereinstimmung mit gesetzten Kodierbolzen) und wenn der Werkstückträger 11 in der richtigen Position ist. Letzeres wird durch die Näherungsschalter 1, 1′ im Lesekopf 14 im Zusammenhang mit der Metallfläche 17 am Werkstückträger 11 ermittelt. Das Signal an den Näherungsschaltern steht solange an, wie der Werkstückträger vor dem Lesekopf steht, mindestens jedoch 50 ms. Hieraus folgt, daß auch bei einer relativ langsamen Steuerung ein schnell vorbei bewegter Werkstückträger erkannt und die Kodierung gelesen werden kann. Ein zusätzliches Setzen von Hilfsspeichern entfällt.

Das Kodiersystem enthält weiterhin einen in der Figur nicht näher dargestellten Schreibkopf. Dieser dient zur Betätigung der Kodierbolzen am Kodierblock und damit zum « Setzen » und « Löschen » von Informationen. Im Schreibkopf sind vier einseitig wirkende Pneumatikzylinder mit Rückstellfedern zusammengefaßt. Die äußere Geometrie entspricht genau derjenigen der Kodierblöcke 12 sowie der Leseköpfe 14, 15. Ein Näherungsschalter ist im Befestigungsbügel integriert, um die Lage des Werkstückträgers zu erfassen. Für jeden Kodierblock ist ein Schreibkopf mit der passenden Anzahl von Schreibeinheiten vorgesehen.

Das erfindungsgemäße Kodiersystem ermöglicht auf wirtschaftliche Weise eine optimale Kodierung der Werkstückträger zur automatischen Erfassung der jeweiligen Bearbeitungszustände bzw. des Montagefortschritts. Durch die programmierbare Auswerteschaltung in den Leseköpfen ist das System äußerst flexibel und kann ohne technischen Aufwand durch einfaches Umschalten auf jede mögliche Montagefolge eingestellt werden.

## Ansprüche

1. Kodiersystem zum Speichern und Auswerten von Informationen über Bearbeitungs-, Montage-, und/oder Lagezustände von Werkstücken in Fertigungs- bzw. Transferstraßen, mit an einem bewegten Werkstückträger zwischen einer ersten und einer zweiten Position verschiebbar gelagerten Kodierbolzen, deren jeweilige Position durch feststehende Sensoren erfaßbar ist, welche an eine programmierbare Auswerteschaltung angeschlossen sind, dadurch gekennzeichnet, daß die Kodierbolzen (18, 19) paarweise derart nebeneinander in Bohrungen in einem Kodierblock (12) verschiebbar gelagert und miteinander gekoppelt sind, daß der eine Kodierbolzen (18) zwangsläufig seine erste Position einnimmt, wenn sich der andere Kodierbolzen (19) in seiner zweiten Position befindet und umgekehrt, daß ferner die beiden einem Kodierbolzenpaar (18, 19) zugeordneten Sensoren (2, 2′ bzw. 3, 3′ usw.) an eine Umschalteinrichtung (30) angeschlossen sind, welche jeweils einen der beiden Sensoren (2, 3 bzw. 2′, 3′ usw.) mit einem logischen Verknüpfungselement (26, 31) der Auswerteschaltung verbindet, und daß ein Lesekopfmodul (14) mit mindestens einem Sensor (1, 1′) zum Erfassen der Lage des Werkstückträgers oder dgl. versehen und dieser Sensor (1, 1′) mit dem logischen Verknüpfungselement (26) der Auswerteschaltung verbunden ist.

2. Kodiersystem nach Anspruch 1, dadurch gekennzeichnet, daß die Auswerteschaltung eine logische Gatteranordnung (26, 31) zur Und-Verknüpfung der durch die Umschalteinrichtungen (30) jeweils aktivierten Sensoren (1 bis 5, 1′ bis 5′) aufweist.

3. Kodiersystem nach Anspruch 1 oder 2, dadurch gekennzeichnet, daß mindestens die beiden, einem Kodierbolzenpaar (18, 19) zugeordneten Sensoren (2, 2′ bzw. 3, 3′ usw.) und ihre Umschaltvorrichtungen (30) in einem Lesekopfmodul (14, 15) untergebracht sind, welcher mit elektrischen Mitteln (27, 28, 29) zum Verbinden mit weiteren Lesekopfmodulen versehen ist.

4. Kodiersystem nach Anspruch 3, dadurch gekennzeichnet, daß die Lesekopfmodule (14, 15) auch das mit der Umschalteinrichtung (30) verbundene logische Verknüpfungselement (26, 31) der Auswerteschaltung enthalten.

5. Kodiersystem nach einem der Ansprüche 3 oder 4, dadurch gekennzeichnet, daß die Bohrungen zur Aufnahme der Kodierbolzen (18, 19) an ein- und derselben Seite des Kodierblocks (12) ausmünden und in dessen Innerem über einen kreisbogenförmigen Kanal (21) verbunden sind, der ein aus einzelnen, sich berührenden Kugeln (20) gebildetes Gestänge zur Koppelung der beiden Kodierbolzen (18, 19) aufnimmt.

**Claims**

1. Coding system for storing and evaluating data relating to machining, assembly and/or position states of workpieces on production or transfer lines, with coding pins which are mounted on a moving workpiece support so as to be displaceable between a first position and a second position and the particular position of which can be detected by fixed sensors connected to a programmable evaluation circuit, characterised in that the coding pins (18, 19) are mounted displaceably in pairs next to one another in bores of a coding block (12) and are coupled to one another, in such a way that the one coding pin (18) necessarily assumes it first position when the other coding pin (19) is in its second position, and vice versa, in that, furthermore, the two sensors (2, 2′ and 3, 3′, etc.) assigned to a pair of coding pins (18, 19) are connected to a change-over device (30) which connects either one of the two sensors (2, 3 and 2′,3′, etc.) to a logical switching element (26, 31) of the evaluation circuit, and in that a reading-head module (14) is provided with at least one sensor (1, 1′) for detecting the position of the workpiece support or the like, and this sensor (1, 1′) is connected to the logical switching element (26) of the evaluation circuit.

2. Coding system according to claim 1, characterised in that the evaluation circuit has a logical gate arrangement (26, 31) for the And operation of the sensors (1 to 5, 1′ to 5′) respectively activated by the change-over devices (30).

3. Coding system according to claim 1 or 2, characterised in that at least the two sensors (2, 2′ and 3, 3′, etc.), assigned to a pair of coding pins (18, 19), and their change-over devices (30) are accomodated in a reading-head module (14, 15) which is provided with electrical means (27, 28, 29) for connection to further reading-head modules.

4. Coding system according to claim 3, characterised in that the reading-head modules (14, 15) also contain the logical switching element (26, 31) connected to the change-over device (30) and belonging to the evaluation circuit.

5. Coding system according to one of claims 3 or 4, characterised in that the bores for receiving the coding pins (18, 19) open out on one and the same side of the coding block (12) and are connected in the interior of the latter via a channel (21) in the form of a circular arc, which receives a linkage which is formed from individual balls (20) touching one another and which is intented for coupling the two coding pins (18, 19).

**Revendications**

1. Système de codage pour mémoriser et exploiter des informations concernant les stades de traitement, de montage et/ou de positionnement de pièces d'œuvre, sur des chaînes de fabrication ou de transfert, système comportant des goujons de codage montés sur un support de pièce d'œuvre en déplacement en étant susceptibles d'être déplacés entre une première et une seconde position, et dont la position respective peut être détectée par des détecteurs fixes, raccordés à un circuit d'exploitation programmable, système de codage caractérisé en ce que les goujons de codage (18, 19) sont montés par paires les uns à côté des autres, dans des perçages d'un bloc de codage (12) et sont couplés ensemble, de façon que l'un (18) des goujons de codage prend obligatoirement sa première position lorsque l'autre goujon de codage (19) se trouve dans sa seconde position et inversement, les deux détecteurs (2, 2′ ou bien 3, 3′, etc...) associés à une paire de goujons de codage (18, 19) étant raccordés à un dispositif de commutation (30) qui relie respectivement un des deux détecteurs (2, 3, ou bien 2', 3', etc...) à un élément de connection logique (26, 31) du circuit d'exploitation, tandis qu'il est prévu un module de tête de lecture (14) avec au moins un détecteur (1, 1') pour détecter la position du support de pièce d'œuvre ou d'un organe analogue, ce détecteur (1, 1') étant relié à l'élément de connection logique (26) du circuit d'exploitation.

2. Système de codage selon la revendication 1, caractérisé en ce que le circuit d'exploitation comporte un dispositif logique de porte (26, 31) pour la connection et des détecteurs (1 à 5, 1' à 5') respectivement activés par les dispositifs d'inversion (30).

3. Système de codage selon une des revendications 1 ou 2, caractérisé en ce qu'au moins les deux détecteurs (2, 2' ou bien 3, 3' etc...) associés à une paire de goujons de codage (18, 19) ainsi que leurs dispositifs d'inversion (30) sont logés dans un module de tête de lecture (14, 15) muni de moyens électriques (27, 28, 29) pour assurer sa liaison avec d'autres modules de tête de lecture.

4. Système de codage selon la revendication 3, caractérisé en ce que les modules de têtes de lecture (14, 15) contiennent également l'élément de connection logique, relié au dispositif d'inversion (30), du circuit d'exploitation.

5. Système de codage selon l'une des revendications 3 ou 4, caractérisé en ce que les perçages destinés à recevoir les goujons de codage (18, 19) débouchent sur un côté, toujours le même, du bloc de codage (12) et sont reliés à l'intérieur de ce bloc par l'intermédiaire d'un canal en forme d'arc de cercle (21) dans lequel est logée une tringlerie, constituée de billes (20) individuelles se touchant, pour coupler les deux goujons de codage (18, 19).

FIG. 1

FIG. 2

FIG. 3

FIG. 4